# EUROPEAN PATENT SPECIFICATION

(11) **EP 3 113 206 B1**
(45) Date of publication and mention of the grant of the patent: **24.10.2018**
(21) Application number: 16001290.2
(22) Date of filing: 08.06.2016
(51) Int. Cl.: H01J 35/14, H01J 37/09

(54) **X-RAY GENERATOR AND ADJUSTMENT METHOD THEREFOR**
RÖNTGENGENERATOR UND ANPASSUNGSVERFAHREN DAFÜR
GÉNÉRATEUR DE RAYONS X ET SON PROCÉDÉ DE RÉGLAGE

(30) Priority: 01.07.2015 JP 2015132907
(43) Date of publication of application: 04.01.2017
(73) Proprietor: Rigaku Corporation, Akishima-shi, Tokyo 196-8666 (JP)
(72) Inventor: Nonoguchi, Masahiro, Akishima-shi, Tokyo, 196-8666 (JP)
(74) Representative: Müller-Boré & Partner Patentanwälte PartG mbB

(56) References cited:
- EP-A1- 1 557 864
- US-A1- 2007 030 958
- US-A1- 2008 080 664

## Description

### CROSS-REFERENCE TO RELATED APPLICATION

The present application claims priority from Japanese application JP 2015-132907, filed on July 1, 2015.

### BACKGROUND OF THE INVENTION

### 1. Field of the Invention

The present invention relates to an X-ray generator and an adjustment method therefor, and more particularly, to a technology for suppressing the effects of a fluctuation in a disturbance magnetic field.

### 2. Description of the Related Art

Apparatus using an electron beam (hereinafter referred to as "electron-beam applied apparatus") include an electron microscope, an electron-beam lithography system, and an X-ray generator. The electron beam is an electron swarm that travels at high speed, in which each electron has a charge. Therefore, the electrons that travel through a magnetic field experience a Lorentz force to change a traveling direction thereof. Thus, the electron-beam applied apparatus are affected by a fluctuation in a disturbance magnetic field.

In order to suppress the effects of the fluctuation in the disturbance magnetic field, some methods are considered to be applicable. A first method is to install the electron-beam applied apparatus in a basement that is insusceptible to the effects of the fluctuation in the disturbance magnetic field. A second method is a magnetic-field shielding method. A space in which the electron-beam applied apparatus is installed is surrounded by magnetic shielding materials such as permalloy materials. Specifically, a magnetic shielding box is manufactured and a bypass path for the disturbance magnetic field is provided therearound. A third method is a magnetic field canceller method. A canceller coil is installed in the periphery of the electron-beam applied apparatus to be installed. The fluctuation in the disturbance magnetic field is detected by a magnetic sensor so as to control the canceller coil, thereby cancelling the fluctuation in the disturbance magnetic field. In JP2003-173755A, there is disclosed a charged-particle beam apparatus including an active magnetic field canceller.

US 2007/0030958 A1 describes methods of designing an x-ray tube shielded for operation in static and dynamic externally applied magnetic fields. The methods include passive shielding of the insert frame, housing, design of an external shield envelope, tube port, tube collimator, and combinations thereof.

US 2008/0080664 A1 describes a method, device and system for adjusting the position of an X-ray tube focus. In order to reduce the influence of magnetic interference fields on the position of an x-ray focus of an x-ray tube, the deviation of a current focus position from a target focus position or of a measurement value proportional to the deviation is determined, the focus position is adjusted by reducing the deviation of the current focus position from the target focus position, or the measurement value proportional to the deviation, on the basis of the determined deviation or the determined measurement value proportional to the deviation. The deviation of the current focus position from the target focus position or the measurement value proportional to the deviation is regulated to a value of essentially zero via repeated determination and correction.

### SUMMARY OF THE INVENTION

However, all the above-mentioned methods have problems in that costs are significantly high and the degree of freedom is extremely limited for a location of installation of the electron-beam applied apparatus and displacement of the electron-beam applied apparatus. When the disturbance magnetic field is generated due to movement of a train, an automobile, an elevator, or the like, which are present outside of a laboratory, the effects of the fluctuation in the disturbance magnetic field can be suppressed by the above-mentioned methods . When the source of generation of the disturbance magnetic field is present inside of the laboratory, however, the effects of the fluctuation in the disturbance magnetic field cannot be suppressed by the above-mentioned methods. In particular, when the electron-beam applied apparatus is the X-ray generator, it is considered that the X-ray generator includes a measurement system along with a plurality of components. When the plurality of components include a component that is the source of generation of the disturbance magnetic field, the X-ray generator is affected by the fluctuation in the disturbance magnetic field generated by the component.

The present invention has been made in view of the above-mentioned problems, and has an object to provide an X-ray generator capable of suppressing effects of a fluctuation in a disturbance magnetic field and an adjustment method therefor.

The present invention is defined by the independent claims. Preferred embodiments are set forth in the dependent claims.
(1) In order to solve the above-mentioned problems, according to one embodiment of the present invention, there is provided an X-ray generator, including: an electron-beam generating unit configured to emit an electron beam; an electron target onto which the electron beam is radiated to generate an X-ray; an electron-beam adjusting unit, which is arranged between the electron-beam generating unit and the electron target, and is configured to adjust the electron beam emitted from the electron-beam generating unit; an electron-beam deflecting unit, which is arranged between the electron-beam adjusting unit and the electron target, and is configured to deflect the electron beam to be radiated onto the electron target; and a magnetic sensor configured to detect a magnetic field in a space between the electron-beam adjusting unit and the electron target, through which the electron beam passes.
(2) In the X-ray generator as described in Item (1), the magnetic sensor may be arranged in a vicinity of a region of the electron target, onto which the electron beam is radiated, so as to be away from the electron beam.
(3) In the X-ray generator as described in Item (1) or (2), the electron-beam deflecting unit may be configured to change a position on the electron target, at which the electron beam is radiated, based on the magnetic field measured by the magnetic sensor.
(4) According to one embodiment of the present invention, there is provided an adjustment method for an X-ray generator configured to radiate an electron beam onto an electron target to generate an X-ray, the adjustment method including: a magnetic-field measurement step of measuring a magnetic field in a vicinity of the electron beam; a deflection-amount calculation step of calculating a deflection amount of the electron beam based on the magnetic field measured in the magnetic-field measurement step; and an electron-beam deflecting unit control step of changing a position on the electron target, at which the electron beam is radiated, based on the deflection amount calculated in the deflection-amount calculation step.

According to the present invention, the X-ray generator capable of suppressing effects of the fluctuation in a disturbance magnetic field and the adjustment method therefor are provided.

### BRIEF DESCRIPTION OF THE DRAWINGS

FIG. 1 is a schematic diagram for illustrating the structure of an X-ray analyzer according to an embodiment of the present invention.
FIG. 2 is a schematic diagram for illustrating the structure of an X-ray generator according to the embodiment of the present invention.
FIG. 3 is a schematic diagram for illustrating the structure of the X-ray generator according to the embodiment of the present invention.
FIG. 4 is a diagram for illustrating an adjustment method for the X-ray generator according to the embodiment of the present invention.

### DETAILED DESCRIPTION OF THE INVENTION

Now, an embodiment of the present invention is described referring to the drawings. For clearer illustration, some sizes, shapes, and the like are schematically illustrated in the drawings in comparison to actual ones. However, the sizes, the shapes, and the like are merely an example, and do not limit understanding of the present invention. Further, like elements as those described relating to the drawings already referred to are denoted by like reference symbols herein and in each of the drawings, and detailed description thereof is sometimes omitted as appropriate.

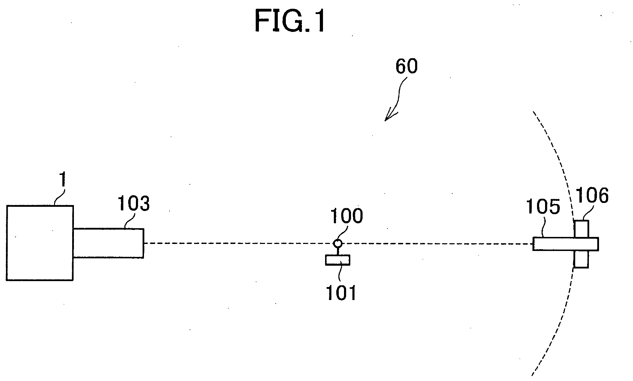

FIG. 1 is a schematic diagram for illustrating the structure of an X-ray analyzer 60 according to an embodiment of the present invention. The X-ray analyzer 60 according to this embodiment is, for example, an X-ray diffraction (XRD) system. The X-ray analyzer 60 includes an X-ray generator 1, a sample stage 101, an optical system 103, an X-ray detector 105, and a rotary drive system 106.

A main feature of the present invention lies in the structure of the X-ray generator 1. The X-ray generator 1 includes an electron-beam deflecting unit and a magnetic sensor. The electron-beam deflecting unit is configured to deflect an electron beam radiated onto an electron target. The magnetic sensor is configured to detect a magnetic field in a space through which the electron beam passes. The electron-beam deflecting unit can change a position on the electron target, at which the electron beam is radiated, based on the magnetic field measured by the magnetic sensor. Details of the X-ray generator 1 are described later.

Now, the structure of the X-ray analyzer 60 according to this embodiment is described. The sample stage 101 includes a needle-like sample holder and at least one rotary drive system. A sample 100 being single crystal is mounted onto a distal end of the needle-like sample holder so that the sample 100 is supported on the sample holder. The optical system 103 includes a multilayer collecting mirror and a collimator. An X-ray emitted from the X-ray generator 1 is collected by the multilayer collecting mirror, and is then emitted to the sample 100 through the collimator. The sample holder is arranged so that the X-ray emitted from the optical system 103 enters the sample 100. Further, another end of the sample holder is fixed to the rotary drive system. The sample 100 can be changed in orientation in three dimensions by the rotary drive system.

The X-ray detector 105 is, for example, a charge coupled device (CCD). When the X-ray is radiated onto the sample 100, a diffracted X-ray is generated from the sample 100. The X-ray detector 105 can detect the diffracted X-ray generated from the sample 100 on a two-dimensional plane. The X-ray detector 105 is arranged on the rotary drive system 106 that is angularly movable about the sample 100. The rotary drive system for the sample stand 101 and the rotary drive system 106 enable the X-ray detector 105 to detect a whole diffraction image of the sample 100. The X-ray detector 105 is not limited to the CCD, and may be any X-ray detector that is capable of detecting the diffraction image of the sample 100. Further, although the single crystal is described as an example of the sample 100, the sample 100 is not limited thereto. The configuration of the X-ray analyzer 60 only needs to be changed depending on kinds of the sample 100 and a purpose of analysis.

As described above, a source of generation of a disturbance magnetic field may be present outside of a laboratory in which the X-ray analyzer 60 is installed (including a case where the source of generation of the disturbance magnetic field is terrestrial magnetism), and may also be present inside of the laboratory. In particular, the X-ray analyzer 60 includes the rotary drive system for the sample stage 101 and the rotary drive system 106 on which the X-ray detector 105 is arranged. Each of the rotary drive systems includes a step motor. When a measurement is carried out by using the X-ray analyzer 60, the step motor that is being driven can be the source of generation of the disturbance magnetic field. Further, during the measurement, the disturbance magnetic field may fluctuate. As described above, when the source of generation of the disturbance magnetic field is present inside of the laboratory, in particular, inside of an experimental apparatus itself, the present invention has remarkable effects.

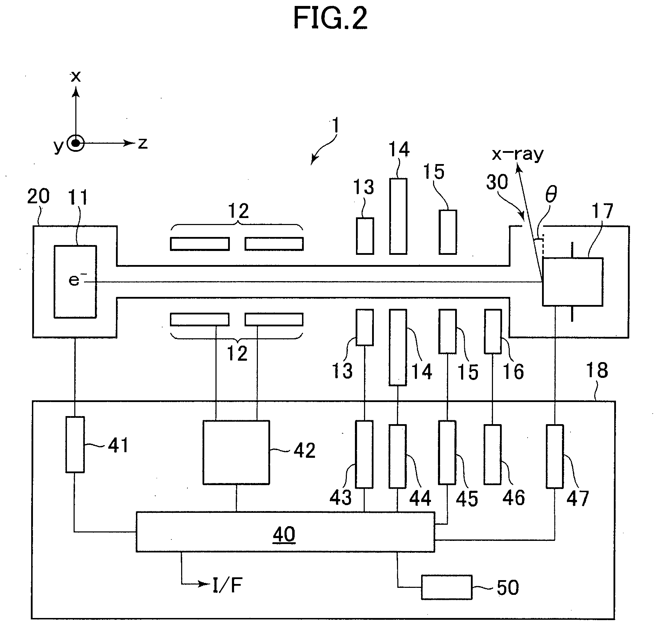

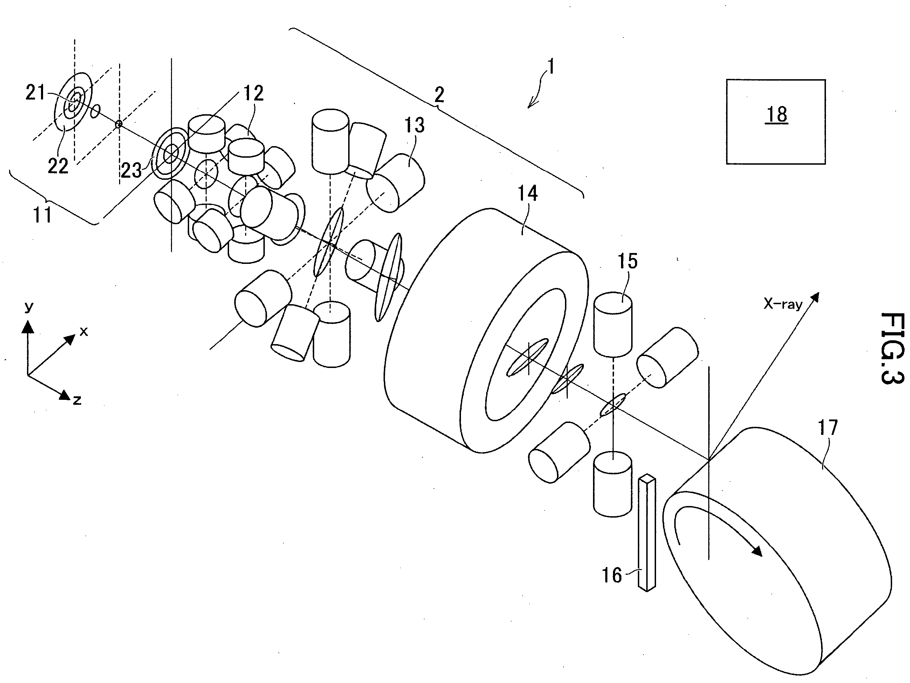

FIG. 2 and FIG. 3 are schematic diagrams for illustrating the structure of the X-ray generator 1 according to the embodiment of the present invention. FIG. 2 is a block diagram of the X-ray generator 1, and FIG. 3 is a perspective view of main components of the X-ray generator 1 with which sectional shapes of an electron beam are illustrated together. In FIG. 2 and FIG. 3, xyz coordinates, which are defined based on an ideal electron beam, are illustrated. A z-axis direction is an optical-axis direction of the electron beam, and an xy plane is a plane perpendicular to the optical axis of the electron beam. An x-axis direction is a flattening direction (long axis direction) in which a cross section of the electron beam radiated onto an electron target is flattened, whereas a y-axis direction is a direction (short axis direction) perpendicular to the flattening direction.

The X-ray generator 1 according to this embodiment includes an electron-beam generating unit 11 (electron gun), an alignment coil 12, a deforming and rotating coil 13, a focusing coil 14, a deflecting coil 15, a magnetic-field probe 16, a rotor target 17 (electron target), a control unit 18, and a chamber 20 (vacuum chamber) . An electron-beam adjusting unit 2 includes the alignment coil 12, the deforming and rotating coil 13, and the focusing coil 14. In the X-ray generator 1 according to this embodiment, a sectional shape of an ideal electron beam on the rotor target 17 is elliptical (elliptical beam). The flattening direction (long axis direction) of the elliptical shape is the same as an axial direction of the rotor target 17. The electron-beam generating unit 11 and the rotor target 17 are housed within the chamber 20 whose interior is maintained in a vacuum state. Each of the components included in the electron-beam adjusting unit 2, the deflecting coil 15, and the magnetic-field probe 16 are arranged outside of the chamber 20.

The rotor target 17 is a rotating member having a columnar shape. Metal is formed in a band-like fashion on a side surface of the rotor target 17. The width of the side surface (height of the column) is 40 mm. The electron beam is radiated on the metal formed on the side surface of the rotor target 17, thereby generating an X-ray. Specifically, the metal formed on the side surface of the rotor target 17 corresponds to the electron target. In this embodiment, the side surface of the rotor target 17 is made of Cu (copper).

The electron beam collides against the rotor target 17, thereby generating an X-ray. Now, a plane (xz plane) formed by the axis of the rotor target 17 and a long axis of the cross section (ellipse) of the electron beam on the side surface of the rotor target 17 is considered. When an angle from the long axis (x-axis direction) in the xz plane is defined as a take-off angle θ, an X-ray window 30 is arranged in a direction that forms θ=14° from a center of a portion where the X-ray is generated (cross section of the electron beam) . A part of the X-ray generated by the rotor target 17, which passes through the X-ray window 30, is emitted outside.

The electron-beam generating unit 11 includes a filament 21, a Wehnelt 22, and an anode 23. A hole is formed in the anode 23. The filament 21 and the Wehnelt 22 construct a cathode. The electrons emitted from the filament 21 are accelerated and pass through the hole of the anode 23 so as to be emitted outside, thereby forming an electron beam. Specifically, the electron-beam generating unit 11 emits the electron beam to be radiated onto the rotor target 17 that is the electron target. The electron beam is focused through the Wehnelt 22 to form a crossover between the filament 21 and the anode 23, and is then spread. Further, the electron beam is adjusted by the focusing coil 14 so that the electron beam forms a focal spot on, for example, the side surface of the rotor target 17. In order to give a smaller focal spot size of the electron beam, it is desirable that a size of the crossover be reduced. Therefore, a material used for the filament 21 is desirably a rare-earth metal compound such as lanthanum hexaboride (LaB6) or cerium hexaboride (CeB6) that can realize a flat small-diameter emitter having a large electron emission density, but the material of the filament 21 is not limited thereto.

The electron-beam adjusting unit 2 is arranged between the electron-beam generating unit 11 and the rotor target 17. The electron beam emitted from the electron-beam generating unit 11 is adjusted so that the electron beam is radiated onto the rotor target 17 under desired conditions . In this case, the electron-beam adjusting unit 2 uses the plurality of coils to adjust the electron beam through a magnetic field. Each of the components included in the electron-beam adjusting unit 2 is described later.

The deflecting coil 15 corresponds to an electron-beam deflecting unit configured to deflect the electron beam to be radiated onto the rotor target 17, and is arranged between the electron-beam adjusting unit 2 and the rotor target 17. The deflecting coil 15 includes a quadrupole coil, and is capable of deflecting the electron beam that has passed through the deflecting coil 15 in any direction in a plane that perpendicularly passes the optical axis of the electron beam before passage through the deflecting coil 15. A principle of the deflecting coil 15 is the same as that of a deflecting coil of an electromagnetic deflection type cathode-ray tube oscilloscope.

The magnetic-field probe 16 is a magnetic sensor including hall elements provided at a distal end thereof and configured to measure a magnetic field at a position of the hall elements (at the distal end of the magnetic-fieldprobe 16). A three-dimensional magnetic sensor capable of detecting components of the magnetic field in three-axis directions corresponding to x-, y-, and z-axis directions is desirable as the magnetic-field probe 16. Although the hall elements configured to detect the components of the magnetic field in the x-axis direction, the y-axis direction, and the z-axis direction are provided at the distal end of the magnetic-field probe 16 in this case, the magnetic-field probe 16 is not limited thereto. It is components of the magnetic field in the xy plane that change a travelling direction of the electron beam travelling in the z-axis direction. Therefore, the magnetic-field probe 16 may also be a two-dimensional magnetic sensor capable of measuring the components of the magnetic field in the xy plane. Further, even when a one-dimensional magnetic sensor is used as the magnetic-field probe 16, the components of the magnetic field in the x-axis direction and the y-axis direction may be measured by rotating the one-dimensional magnetic sensor by 90°.

The magnetic-field probe 16 is arranged outside of the chamber 20 so as to be located between the electron-beam adjusting unit 2 and the rotor target 17, as illustrated in FIG. 2 and FIG. 3. Specifically, the magnetic-field probe 16 is arranged so as to be away from the electron beam. The magnetic-field probe 16 is a magnetic sensor configured to detect the magnetic field in a space between the electron-beam adjusting unit 2 and the rotor target 17, through which the electron beam passes. A fluctuation in a disturbance magnetic field in the space from an exit of the electron-beam adjusting unit 2 to a radiating position of the electron beam on the rotor target 17 causes a change in radiating position of the electron beam on the rotor target 17. It is desirable to arrange the magnetic-field probe 16 so that the magnetic field that is actually measured by the magnetic-field probe 16 is located as close as possible to the electron beam passing through the space to such a degree that the magnetic field measured by the magnetic-field probe 16 can be approximated to be equal to the magnetic field in the space between the electron-beam adjusting unit 2 and the rotor target 17, through which the electron beam passes. Specifically, the magnetic field that is actually measured by the magnetic-field probe 16 is desirably located within a range of 30 mm, more desirably, within a range of 10 mm from a center of the electron beam. As described above, the magnetic-field probe 16 is arranged outside of the chamber 20, and is desirably located within a range of 5 mm, more desirably, within a range of 2 mm from an outer edge of the chamber 20.

The magnetic-field probe 16 (magnetic sensor) is provided inside of the X-ray generator 1. Thus, the magnetic-field probe 16 can detect the magnetic field in the space between the electron-beam adjusting unit 2 and the rotor target 17, through which the electron beam passes. However, the magnetic field in the space through which the electron beam actually passes cannot be detected while the X-ray generator 1 is operating to emit the X-ray. Therefore, the magnetic-field probe 16 is arranged in the vicinity of a region of the rotor target 17, onto which the electron beam is radiated, so as to be away from the electron beam. As a result, the magnetic-field probe 16 can detect the magnetic field that can be approximated to be equal to the magnetic field in the space through which the electron beam actually passes.

The control unit 18 controls the electron-beam adjusting unit 2 to adjust the electron beam so that the electron beam emitted from the electron-beam generating unit 11 is radiated onto the rotor target 17 under desired conditions. The control unit 18 includes a CPU 40, an electron-beam generating unit control unit 41, an alignment coil control unit 42, a deforming and rotating coil control unit 43, a focusing coil control unit 44, a deflecting coil control unit 45, a magnetic-field probe control unit 46, a rotor target control unit 47, and a memory 50. The electron-beam generating unit control unit 41, the alignment coil control unit 42, the deforming and rotating coil control unit 43, the focusing coil control unit 44, the deflecting coil control unit 45, the magnetic-field probe control unit 46, and the rotor target control unit 47 respectively control the electron-beam generating unit 11, the alignment coil 12, the deforming and rotating coil 13, the focusing coil 14, the deflecting coil 15, the magnetic-field probe 16, and the rotor target 17. Signal data input to the CPU 40 or output from the CPU 40 can be input and output through an external interface (I/F) . The signal data may also be stored in the memory 50. A result of computation performed in the CPU 40 is stored in the memory 50. The result of computation performed in the CPU 40 can be output externally through the external interface (I/F) . The control unit 18 is realized by a commercially available computer device and control circuits for the respective components. The control unit 18 may be built in the X-ray generator 1, or the control unit 18 may be partially or entirely arranged outside of the X-ray generator 1.

Next, the components included in the electron-beam adjusting unit 2 are described. The alignment coil 12 is an electron beam optical-axis adjusting unit configured to adjust the optical axis of the electron beam. The optical axis of the electron beam emitted from the electron-beam generating unit 11 is adjusted (aligned) by the alignment coil 12 so that the optical axis of the electron beam becomes closer to a center of a magnetic field generated by the deforming and rotating coil 13 and a center of a magnetic field generated by the focusing coil 14. It is more desirable that the optical axis of the electron beam coincide with the center of the magnetic field generated by the deforming and rotating coil 13 and the center of the magnetic field generated by the focusing coil 14.

The alignment coil 12 includes two coil sets arranged along the optical axis of the electronic beam (z-axis direction), each coil set being a quadrupole coil. A combination of rotation about the x axis and rotation about the y axis is sequentially performed by the two quadrupole coils so that the optical axis of the electron beam can be brought closer to a center of the xy plane while being brought closer to the z-axis direction in parallel thereto.

The deforming and rotating coil 13 is an electron beam cross-section shaping unit configured to change a sectional shape of the electron beam. The cross section of the electron beam is shaped into an elliptical shape by the deforming and rotating coil 13. The deforming and rotating coil 13 includes an octopole coil. The deforming and rotating coil 13 includes the octopole coil so that the cross section of the electron beam can be shaped into the elliptical shape having a desired flattening ratio (ratio of a longer diameter and a shorter diameter) and a desired flattening direction (long axis direction). For example, the cross section of the electron beam is flattened so that the longer diameter becomes, for example, four times as large as the shorter diameter (flattening ratio of 4:1) . As described above, the part of the X-ray generated from the rotor target 17, which is emitted in the direction at the take-off angle θ of 14°, is externally emitted. A focal spot size of the X-ray is substantially equal to the beam size of the electron beam that is radiated onto the electron target. When the X-ray is emitted at the above-mentioned take-off angle, an apparent focal spot size of the X-ray is such that the length (longer diameter) of the cross section of the electron beam in the long axis direction on the rotor target 17 is compressed to 1/4. Therefore, when the cross section of the electron beam on the rotor target 17 has such an elliptical shape that the longer diameter is four times as large as the shorter diameter, the apparent focal spot of the X-ray becomes a micro focal spot having a circular shape (dot) in this case. When the micro focal spot having a circular shape is desired as the focal spot of the X-ray emitted from the X-ray generator, the flattening ratio of the cross section of the electron beam only needs to be determined in accordance with the take-off angle θ.

Further, when the electron beam passes through the focusing coil 14, not only the electron beam is focused to the focal spot but also the cross section of the electron beam rotates. In the X-ray generator according to this embodiment, the deflecting coil 15 and the magnetic-field probe 16 are required to be arranged between the focusing coil 14 and the rotor target 17. Therefore, it is not desirable to further arrange the deforming and rotating coil 13 between the focusing coil 14 and the rotor target 17. Hence, in the X-ray generator according to this embodiment, the deforming and rotating coil 13 is arranged so as to be closer to the electron-beam generating unit 11 than the focusing coil 14. The flattening direction of the cross section of the electron beam after the passage through the deforming and rotating coil 13 only needs to be determined in consideration of a rotation angle of the rotation caused through the passage through the focusing coil 14 so that the flattening direction of the cross section, of the electron beam on the rotor target 17 is along the axial direction of the rotor target 17. The deforming and rotating coil 13 can set the flattening direction of the cross section of the electron beam to a desired direction, and hence a test electron beam obtained by rotating the flattening direction of the cross section of the electron beam by 90° can be easily generated.

As described above, the deforming and rotating coil 13 includes the octopole coil. The octopole coil is composed of two quadrupole coils. The two quadrupole coils include a first quadrupole coil arranged so that four poles are oriented in negative and positive directions of the x axis and the y axis and a second quadrupole coil located at positions rotated by 45° from the positions of the first quadrupole coil with respect to the z axis.

The focusing coil 14 is an electron-beam focusing unit configured to focus the electron beam to the rotor target 17. The focusing coil 14 is a magnetic field-type electron lens. The electron beam emitted from the electron-beam generating unit 11 passes through the alignment coil 12 and the deforming and rotating coil 13 while being spread, and is then focused by the focusing coil 14. A focusing distance (focal length of the lens) indicating the degree of focusing the electron beam can be controlled by a current flowing through the focusing coil 14 (focusing-coil current) . It is desirable that the electron beam form the focal spot on the side surface of the rotor target 17. As described above, the cross section of the electron beam rotates as the electron beam passes through the focusing coil 14. An orbital rotation angle Ψ of the electrons is expressed by: Ψ=0.186·I·N/√V₀ (I: the focusing-coil current, N: the number of turns of the focusing coil, Vo: an electron accelerating voltage) . The electron accelerating voltage V₀ is a voltage across the filament 21 and the anode 23.

The structure of the X-ray generator according to this embodiment has been described above. In a related-art X-ray generator, the target is set at a ground voltage. By an electric field formed by three poles corresponding to the ground voltage, a cathode voltage, and a bias voltage, the electron beam emitted from the filament is focused on the target. A focal spot size of the X-ray generated from the X-ray generator described above is Φ70 µm or larger. In order to realize the micro focal spot having the X-ray focal spot size of Φ70 µm or smaller, it is desirable that the electron beam optical-axis adjusting unit, the electron beam cross-section shaping unit, and the electron-beam focusing unit magnetically adjust the electron beam as in the case of the electron-beam adjusting unit of this embodiment. By the X-ray generator including the electron-beam adjusting unit described above, the generation of the X-ray having the focal spot size of Φ70 µm or smaller is realized. It is difficult to realize the X-ray having the focal spot size of Φ50 µm or smaller in the related-art X-ray generator. The generation of the X-ray having the focal spot size typically of Φ20 µm or smaller can be realized by the X-ray generator of this embodiment.

Inparticular, the electronbeamoptical-axis adjusting unit, the electron beam cross-section shaping unit, and the electron-beam focusing unit are arranged in the stated order from the electron-beam generating unit side to the electron target side in the electron-beam adjusting unit. As a result, the degree of freedom of a space that is present between the electron-beam focusing unit and the electron target is increased so that the electron-beam deflecting unit, the magnetic sensor, and the like can be arranged as in this embodiment. When the electron beam cross-section shaping unit changes the cross section of the electron beam from the circular shape to a flattened shape, the cross section of the electron beam rotates as the electron beam passes through the electron-beam focusing unit, as described above. However, when the electron beam cross-section shaping unit changes the shape of the cross section of the electron beam in consideration of the rotation angle as in this embodiment, the cross section of the electron beam can be shaped into a desired shape on the electron target even in the above-mentioned arrangement.

The alignment coil 12, the deforming and rotating coil 13, and the focusing coil 14 included in the electron-beam adjusting unit 2 according to this embodiment have a principle in common with components included in an apparatus using the electron beam, such as an electron microscope or an electron beam lithography system. In particular, the deforming and rotating coil according to this embodiment has a principle in common with a stigmator (octopole coil) used for the electron microscope. However, the deforming and rotating coil according to this embodiment is provided for the purpose of intentionally shaping the cross section of the electron beam into the elliptical shape (flattened shape), whereas the stigmator is provided for astigmatism correction, specifically, for the purpose of making the sectional shape of the electron beam closer to the circular shape when the sectional shape of the electron beam is not circular. Therefore, the intended purposes of the deforming and rotating coil and the stigmator are completely different from each other.

Further, the related-art X-ray generator has a small degree of freedom in adjustment of the electron beam. Thus, the focal spot size of the X-ray may vary within a range of about ±5% due to replacement of the filament. In a measurement apparatus (such as a single crystal structural analyzer or an X-ray microscope) including the X-ray generator that emits the X-ray having the focal spot size of Φ70 µm or larger, however, the above-mentioned variation in focal spot size of the X-ray is not regarded as a serious problem. As described above, in order to realize the micro focal spot having the X-ray focal spot size of Φ70 µm or smaller, it is desirable that the electron beam optical-axis adjusting unit, the electron beam cross-section shaping portion, and the electron-beam focusing unit magnetically adjust the electron beam. However, the electron-beam adjusting unit is required to be arranged between the electron-beam generating unit and the electron target in this case. As a result, a distance between the electron-beam generating unit and the electron target becomes extremely longer than (for example, 10 times as large as or longer) that in the related-art X-ray generator. Therefore, the focal spot size is varied sensitively to a fluctuation in current (focusing-coil current) flowing through the focusing coil (focusing lens) that is the electron-beam focusing unit, for example. The electron beam can be adjusted by the present invention, and the present invention has remarkable effects therein. Further, for example, when the cross section of the electron beam on the electron target is excessively reduced by the focusing coil by error, it is considered that the electronic target may be damaged. Therefore, it is important to adjust the electron beam at a low output before the X-ray is emitted at a high output.

Further, in the measurement apparatus including the X-ray generator configured to emit the X-ray having the focal spot size of Φ 70 µm or larger, even when the radiating position of the electron beam on the electron target changes to change a focal spot position of the X-ray due to the fluctuation in the disturbance magnetic field, the change in focal spot position does not become a serious problem. When the focal spot size of the X-ray generated by the X-ray generator becomes smaller, the change in focal spot position of the X-ray has greater effects on accuracy of measurement by the measurement apparatus. The arrangement of the multilayer collecting mirror included in the optical system is determined for the focal spot position of the X-ray generated by the X-ray generator. Once the arrangement of the multilayer collecting mirror is determined, it is difficult to change the arrangement of the multilayer collecting mirror after the start of measurement. Therefore, when the focal spot position of the X-ray generated by the X-ray generator changes due to the fluctuation in the disturbance magnetic field after positions of the X-ray generator and the optical system are determined, the accuracy of measurement is disadvantageously lowered.

In the X-ray analyzer according to this embodiment, the electron-beam deflecting unit changes the position on the electron target, at which the electron beam is radiated, based on the magnetic field measured by the magnetic sensor, thereby being capable of adjusting the focal spot position of the X-ray generated by the X-ray generator. When the X-ray·analyzer includes the source of generation of the disturbance magnetic field such as the step motor, the present invention has particularly remarkable effects.

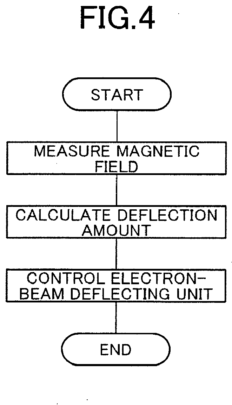

Now, an adjustment method of adjusting the position on the electron target, at which the electron beam is radiated, in the X-ray generator according to this embodiment is described. FIG. 4 is a flowchart for illustrating an adjustment method for the X-ray generator 1 according to this embodiment. The adjustment method described below is realized through control performed by the control unit 18 on the deflecting coil 15 (electron-beam deflecting unit) and the magnetic-field probe 16 (magnetic sensor) .

### [S1: Magnetic-Field Measurement Step]

The magnetic field in the vicinity of the electron beam is measured. Specifically, the magnetic-field probe 16 measures, with the hall elements arranged at the distal end of the magnetic-field probe 16, the magnetic field at the position at which the hall elements are located. Voltages (or currents) detected by the hall elements are detected so that the magnetic-field probe control unit 46 acquires values of the voltages (or the currents). The magnetic-field probe control unit 46 calculates the components in the x-axis direction, the y-axis direction, and the z-axis direction of the magnetic field at the above-mentioned position based on the acquired values of the voltages (or the currents).

### [S2: Deflection-Amount Calculation Step]

A deflection amount of the electron beam is calculated based on the magnetic field measured in the magnetic-field measurement step. When the electrons travel in the magnetic field having the component perpendicular to the travelling direction, the electrons experience a Lorenz force to change the travelling direction. When it is assumed that the magnetic field in the space from the exit of the electron-beam adjusting unit 2 (focusing coil 14) to the radiating region of the rotor target 17 is constant, the deflection amount of the electron beam can be calculated from the distance from the exit of the electron-beam adjusting unit 2 (focusing coil 14) to the radiating region of the rotor target 17, and the magnetic field. When the electrons (eachhaving amass m and having a negative charge with an absolute value e) pass through the space in which a magnetic field having a length L and an intensity B is present at a speed v₀, the electrons are deflected at an angle α (deflection angle α) obtained by: B·R=mv₀/e (Expression 1) with respect to the optical axis of the electron beam emitted from the electron-beam adjusting unit 2 (rotation radius R is obtained by: L≈R·α). The speed v₀ is obtained by: (1/2)mv₀²=eV₀ (V₀ is the electron accelerating voltage).

The electrons traveling in the z-axis direction is deflected by the magnetic field having the component in the x-axis direction and the component in the y-axis direction. The deflection amount of the electron beam may also be expressed by an orientation of deflection (unit vector e_{θ} in the xy plane) and the deflection angle α. Further, the deflection amount of the electron beam may be expressed by xy coordinates of the position on the rotor target 17, at which the electron beam is actually radiated. Further, the deflection amount of the electron beam may be expressed by other methods.

### [S3: Electron-Beam Deflecting Unit Control Step]

The position on the electron target, at which the electron beam is radiated, is changed based on the deflection amount calculated in the deflection-amount calculation step. The deflection-coil control unit 45 controls a desired current to flow through the deflecting coil 15 so that the deflecting coil 15 deflects the electron beam such that the deflection amount of the electron beam, which is calculated based on the measured magnetic field, is cancelled out. As a result, the position on the rotor target 17, at which the electron beam is radiated, is changed so as to adjust the focal spot position of the X-ray.

The adjustment method of adjusting the position on the electron target, at which the electron beam is radiated, has been described above. By repeatedly carrying out the above-mentioned adjustment method during the operation of the X-ray generator, the focal spot position of the X-ray can be adjusted in real time. As described above, the X-ray analyzer 60 according to this embodiment is not limited to the X-ray diffraction system illustrated in FIG. 1. For example, the X-ray analyzer 60 may be an X-ray film thickness meter. The X-ray analyzer 60 being the X-ray film thickness meter includes the X-ray generator 1 configured to generate the X-ray having a micro focal spot of 20 µm or smaller, a mirror, and a sample stage configured to support the sample. During the measurement, the sample stage is displaced with respect to the X-ray generator 1 by a step motor built in the sample stage. Leakage magnetic flux generated from the step motor (electromagnetic motor) built in the sample stage causes the fluctuation in the disturbance magnetic field in the X-ray generator 1 to cause a change in focal spot position of the X-ray. A position of the mirror is fixed, and hence intensity of the X-ray radiated onto the sample is disadvantageously lowered. According to the X-ray generator 1 of this embodiment, however, the position on the electron target, at which the electron beam is radiated, can be changed. Therefore, the present invention provides particular effects therein. For example, when the electrons accelerated at the electron accelerating voltage V₀=40 kV passes through the space with the presence of the magnetic field having the length L=10 mm and the intensity B= 1.2 gauss, the electron beam is deflected by 17 µm between an incident position to the space and an exit position from the space, as viewed from an electron incident direction on a plane. Specifically, in the X-ray generator configured to generate an X-ray having a micro focal spot of 10 µm as the focal spot size, the focal spot position is greatly changed by the amount larger than the focal spot size (or a beam diameter) even with the fluctuation in the disturbance magnetic field of 1.2 gauss.

The X-ray generator according to the embodiment of the present invention and the adjustment method therefor have been described above. The X-ray generator according to the present invention can be widely applied without being limited to the above-mentioned embodiment. For example, each of the electron-beam adjusting unit and the electron-beam deflecting unit included in the X-ray generator according to the embodiment described above includes (the plurality of) coils to magnetically control the electron beam. However, the electron-beam adjusting unit and the electron-beam deflecting unit are not limited thereto, and may be realized by other elements having similar functions.

## Claims

1. An X-ray generator (1), comprising:
an electron-beam generating unit (11) configured to emit an electron beam;
an electron rotor target (17) which has a columnar shape and onto which the electron beam is radiated to generate an X-ray; and
an electron-beam adjusting unit (2), which is arranged between the electron-beam generating unit (11) and the electron rotor target (17), and is configured to adjust the electron beam emitted from the electron-beam generating unit, wherein
the electron beam adjusting unit (2) comprises:
an electron beam optical-axis adjusting unit (12) configured to adjust an optical axis of the electron beam;
an electron beam cross-section shaping unit (13) configured to change a sectional shape of the electron beam; and
an electron-beam focusing unit (14) configured to focus the electron beam onto the electron rotor target (17); and
the X-ray generator (1) further comprises:
an electron-beam deflecting unit (15), which is arranged between the electron-beam adjusting unit (2) and the electron rotor target (17), and is configured to deflect the electron beam to be radiated onto the electron rotor target (17); and
a magnetic sensor (16) configured to detect a magnetic field in a space between the electron-beam adjusting unit (2) and the electron rotor target (17), through which the electron beam passes.

2. The X-ray generator (1) according to claim 1, wherein the magnetic sensor (16) is arranged in a vicinity of a region of the electron rotor target (17), onto which the electron beam is radiated, so as to be away from the electron beam.

3. The X-ray generator (1) according to claim 1 or 2, wherein the electron-beam deflecting unit (15) is configured to change a position on the electron rotor target (17), at which the electron beam is radiated, based on the magnetic field measured by the magnetic sensor (16).

4. An adjustment method for an X-ray generator (1) configured to radiate an electron beam onto an electron rotor target (17) having a columnar shape so as to generate an X-ray, the X-ray generator (1) comprising:
an electron-beam generating unit (11) configured to emit an electron beam;
an electron-beam adjusting unit (2), which is arranged between the electron-beam generating unit (11) and the electron rotor target (17), and is configured to adjust the electron beam emitted from the electron-beam generating unit (11); and
an electron-beam deflecting unit (15), which is arranged between the electron-beam adjusting unit (2) and the electron rotor target (17), and is configured to deflect the electron beam to be radiated onto the electron rotor target (17); and
a magnetic sensor (16) configured to detect a magnetic field in a space between the electron-beam adjusting unit (2) and the electron rotor target (17), through which the electron beam passes,
wherein the electron-beam adjusting unit (2) comprises:
an electron beam optical-axis adjusting unit (12) configured to adjust an optical axis of the electron beam;
an electron beam cross-section shaping unit (13) configured to change a sectional shape of the electron beam; and
an electron-beam focusing unit (14) configured to focus the electron beam onto the electron rotor target (17); and
the adjustment method comprises:
a magnetic-field measurement step of measuring a magnetic field in a vicinity of the electron beam by using the magnetic sensor (16);
a deflection-amount calculation step of calculating a deflection amount of the electron beam based on the magnetic field measured in the magnetic-field measurement step; and
an electron-beam deflecting unit control step of changing a position on the electron rotor target (17), at which the electron beam is radiated, based on the deflection amount calculated in the deflection-amount calculation step by using the electron-beam deflecting unit (15).

## Patentansprüche

1. Röntgengenerator (1), umfassend:
eine Elektronenstrahlerzeugungseinheit (11), die konfiguriert ist, einen Elektronenstrahl zu emittieren;
ein Elektronenrotorziel (17), das eine säulenartige Form aufweist und auf das der Elektronenstrahl gestrahlt wird, um einen Röntgenstrahl zu erzeugen; und
eine Elektronenstrahleinstelleinheit (2), die zwischen der Elektronenstrahlerzeugungseinheit (11) und dem Elektronenrotorziel (17) angeordnet ist und
konfiguriert ist, den von der Elektronenstrahlerzeugungseinheit emittierten Elektronenstrahl einzustellen,
wobei die Elektronenstrahleinstelleinheit (2) umfasst:
eine Elektronenstrahl-Optische-Achse-Einstelleinheit (12), die konfiguriert ist, eine optische Achse des Elektronenstrahls einzustellen;
eine Elektronenstrahl-Querschnittsformungseinheit (13), die konfiguriert ist, eine Querschnittsform des Elektronenstrahls zu ändern; und
eine Elektronenstrahlfokussiereinheit (14), die konfiguriert ist, den Elektronenstrahl auf das Elektronenrotorziel (17) zu fokussieren; und
wobei der Röntgengenerator (1) ferner umfasst:
eine Elektronenstrahlablenkeinheit (15), die zwischen der Elektronenstrahleinstelleinheit (2) und dem Elektronenrotorziel (17) angeordnet ist und konfiguriert ist, den auf das Elektronenrotorziel (17) zu strahlenden Elektronenstrahl abzulenken; und
einen Magnetsensor (16), der konfiguriert ist, ein Magnetfeld in einem Raum zwischen der Elektronenstrahleinstelleinheit (2) und dem Elektronenrotorziel (17) zu detektieren, durch den der Elektronenstrahl läuft.

2. Röntgengenerator (1) nach Anspruch 1, wobei der Magnetsensor (16) in der Nähe eines Bereichs des Elektronenrotorziels (17) angeordnet ist, auf das der Elektronenstrahl gestrahlt wird, um weg von dem Elektronenstrahl zu sein.

3. Röntgengenerator (1) nach Anspruch 1 oder 2, wobei die Elektronenstrahlablenkeinheit (15) konfiguriert ist, eine Position auf dem Elektronenrotorziel (17) zu ändern, an welcher der Elektronenstrahl eingestrahlt wird, basierend auf dem von dem Magnetsensor (16) gemessenen Magnetfeld.

4. Einstellverfahren für einen Röntgengenerator (1), der konfiguriert ist, einen Elektronenstrahl auf ein Elektronenrotorziel (17) zu strahlen, das eine säulenartige Form aufweist, um einen Röntgenstrahl zu erzeugen, wobei der Röntgengenerator (1) umfasst:
eine Elektronenstrahlerzeugungseinheit (11), die konfiguriert ist, einen Elektronenstrahl zu emittieren;
eine Elektronenstrahleinstelleinheit (2), die zwischen der Elektronenstrahlerzeugungseinheit (11) und dem Elektronenrotorziel (17) angeordnet ist und konfiguriert ist, den von der Elektronenstrahlerzeugungseinheit (11) emittierten Elektronenstrahl einzustellen; und
eine Elektronenstrahlablenkeinheit (15), die zwischen der Elektronenstrahleinstelleinheit (2) und dem Elektronenrotorziel (17) angeordnet ist und konfiguriert ist, den auf das Elektronenrotorziel (17) zu strahlenden Elektronenstrahl abzulenken; und
einen Magnetsensor (16), der konfiguriert ist, ein Magnetfeld in einem Raum zwischen der Elektronenstrahleinstelleinheit (2) und dem Elektronenrotorziel (17) zu detektieren, durch den der Elektronenstrahl läuft,
wobei die Elektronenstrahleinstelleinheit (2) umfasst:
eine Elektronenstrahl-Optische-Achse-Einstelleinheit (12), die konfiguriert ist, eine optische Achse des Elektronenstrahls einzustellen;
eine Elektronenstrahl-Querschnittsformungseinheit (13), die konfiguriert ist, eine Querschnittsform des Elektronenstrahls zu ändern; und
eine Elektronenstrahlfokussiereinheit (14), die konfiguriert ist, den Elektronenstrahl auf das Elektronenrotorziel (17) zu fokussieren; und
wobei das Einstellverfahren umfasst:
einen Magnetfeld-Messschritt zum Messen eines Magnetfelds in einer Nähe des Elektronenstrahls unter Verwendung des Magnetsensors (16);
einen Ablenkungsbetrag-Berechnungsschritt zum Berechnen eines Ablenkungsbetrags des Elektronenstrahls basierend auf dem Magnetfeld, das in dem Magnetfeld-Messschritt gemessen wird; und
einen Elektronenstrahlablenkeinheit-Steuerungs- bzw. -Regelungsschritt zum Ändern einer Position auf dem Elektronenrotorziel (17), an welcher der Elektronenstrahl eingestrahlt wird, basierend auf dem Ablenkungsbetrag, der in dem Ablenkungsbetrag-Berechnungsschritt unter Verwendung der Elektronenstrahlablenkeinheit (15) berechnet wird.

## Revendications

1. Générateur de rayons X (1) comprenant :
un module de génération de faisceau électronique (11) configuré pour émettre un faisceau électronique ;
une cible de rotor électronique (17) qui a une forme colonnaire et sur laquelle le faisceau électronique est rayonné pour générer un rayon X ; et
un module d'ajustement de faisceau électronique (2) qui est agencé entre le module de génération de faisceau électronique (11) et la cible de rotor électronique (17), et est configuré pour ajuster le faisceau électronique émis depuis le module de génération de faisceau électronique,
dans lequel
le module d'ajustement de faisceau électronique (2) comprend :
un module d'ajustement d'axe optique de faisceau électronique (12) configuré pour ajuster un axe optique du faisceau électronique ;
un module de mise en forme de section transversale de faisceau électronique (13) configuré pour changer une forme de section du faisceau électronique ; et un module de concentration de faisceau électronique (14) configuré pour concentrer le faisceau électronique sur la cible de rotor électronique (17) ; et
le générateur de rayons X (1) comprend en outre :
un module de déviation de faisceau électronique (15) qui est agencé entre le module d'ajustement de faisceau électronique (2) et la cible de rotor électronique (17), et est configuré pour dévier le faisceau électronique devant être rayonné sur la cible de rotor électronique (17) ; et
un capteur magnétique (16) configuré pour détecter un champ magnétique dans un espace entre le module d'ajustement de faisceau électronique (2) et la cible de rotor électronique (17) à travers lequel le faisceau électronique passe.

2. Générateur de rayons X (1) selon la revendication 1, dans lequel le capteur magnétique (16) est agencé à proximité d'une région de la cible de rotor électronique (17) sur laquelle le faisceau électronique est rayonné de manière à être à l'écart du faisceau électronique.

3. Générateur de rayons X (1) selon la revendication 1 ou 2, dans lequel le module de déviation de faisceau électronique (15) est configuré pour changer une position sur la cible de rotor électronique (17) à laquelle le faisceau électronique est rayonné en fonction du champ magnétique mesuré par le capteur électronique (16).

4. Procédé d'ajustement pour un générateur de rayons X (1) configuré pour rayonner un faisceau électronique sur une cible de rotor électronique (17) ayant une forme colonnaire de manière à générer un rayon X, le générateur de rayons X(1) comprenant :
un module de génération de faisceau électronique (11) configuré pour émettre un faisceau électronique ;
un module d'ajustement de faisceau électronique (2) qui est agencé entre le module de génération de faisceau électronique (11) et la cible de rotor électronique (17), et est configuré pour ajuster le faisceau électronique émis depuis le module de génération de faisceau électronique (11) ; et
un module de déviation de faisceau électronique (15) qui est agencé entre le module d'ajustement de faisceau électronique (2) et la cible de rotor électronique (17), et est configuré pour dévier le faisceau électronique devant être rayonné sur la cible de rotor électronique (17) ; et
un capteur magnétique (16) configuré pour détecter un champ magnétique dans un espace entre le module d'ajustement de faisceau électronique (2) et la cible de rotor électronique (17) à travers lequel le faisceau électronique passe,
dans lequel
le module d'ajustement de faisceau électronique (2) comprend :
un module d'ajustement d'axe optique de faisceau électronique (12) configuré pour ajuster un axe optique du faisceau électronique ;
un module de mise en forme de section transversale de faisceau électronique (13) configuré pour changer une forme de section du faisceau électronique ; et un module de concentration de faisceau électronique (14) configuré pour concentrer le faisceau électronique sur la cible de rotor électronique (17) ; et
le procédé d'ajustement comprend :
une étape de mesure de champ magnétique consistant à mesurer un champ magnétique à proximité du faisceau électronique en utilisant le capteur magnétique (16) ;
une étape de calcul de quantité de déviation consistant à calculer une quantité de déviation du faisceau électronique en fonction du champ magnétique mesuré dans l'étape de mesure de champ magnétique ; et
une étape de commande de module de déviation de faisceau électronique consistant à changer une position sur la cible de rotor électronique (17) à laquelle le faisceau électronique est rayonné en fonction de la quantité de déviation calculée dans l'étape de calcul de quantité de déviation en utilisant le module de déviation de faisceau électronique (15).
